# EUROPÄISCHE PATENTSCHRIFT

(11) **EP 2 853 029 B1**
(45) Veröffentlichungstag und Bekanntmachung des Hinweises auf die Patenterteilung: **18.05.2016**
(21) Anmeldenummer: 13756304.5
(22) Anmeldetag: 23.05.2013
(51) Int. Cl.: H03L 7/08, H03L 7/085, H03L 7/099

(54) **SCHALTUNGSANORDNUNG UND VERFAHREN ZUM KALIBRIEREN VON ANSTEUERSIGNALEN FÜR SPANNUNGSGESTEUERTE OSZILLATOREN**
CIRCUIT ARRANGEMENT AND METHOD FOR CALIBRATING ACTIVATION SIGNALS FOR VOLTAGE-CONTROLLED OSCILLATORS
CIRCUIT ET PROCÉDÉ D'ÉTALONNAGE DE SIGNAUX DE COMMANDE POUR OSCILLATEURS COMMANDÉS EN TENSION

(30) Priorität: 23.05.2012 DE 102012104472
(43) Veröffentlichungstag der Anmeldung: 01.04.2015
(73) Patentinhaber: Silicon Line GmbH, 80687 München (DE)
(72) Erfinder: WERKER, Heinz, 82386 Huglfing (DE)
(74) Vertreter: Hofmann, Andreas
(86) Internationale Anmeldenummer: PCT/DE2013/200016
(87) Internationale Veröffentlichungsnummer: WO 2013/174377

(56) Entgegenhaltungen:
- EP-A2- 0 739 089
- US-B1- 6 259 326
- US-B1- 7 129 763

## Beschreibung

### Technisches Gebiet

Die vorliegende Erfindung betrifft grundsätzlich das technische Gebiet des Ansteuerns mindestens eines spannungsgesteuerten Oszillators für Schaltungen zur Takt- und Datenrückgewinnung (= CDR = Clock and Data Recovery); im Spezielleren betrifft die vorliegende Erfindung eine Schaltungsanordnung gemäß dem Oberbegriff des Anspruchs 1 sowie ein Verfahren gemäß dem Oberbegriff des Anspruchs 13.

### Stand der Technik, insbesondere dessen Nachteile und technische Probleme

Bei derartigen Schaltungen zur Takt- und Datenrückgewinnung oder CDR-Schaltungen wird grundsätzlich die Art des Phasendetektors unterschieden:
- linearer Phasendetektor:
   die lineare Phasendifferenz an beiden Eingängen des Phasendetektors wird am Ausgang des Phasendetektors angezeigt;
- binärer Phasendetektor:
   am Ausgang des Phasendetektors wird das Vorzeichen der Phasendifferenz der beiden Eingänge des Phasendetektors ermittelt (voreilend oder nacheilend); dies kann zum Beispiel durch zwei digitale Phasendetektor-Ausgangssignale "up" (für voreilend) und "down" (für nacheilend) angezeigt werden oder aber durch ein Phasendetektor-Ausgangssignal, das drei verschiedene Ausgangspegel annehmen kann, zum Beispiel 200 Millivolt für voreilend, 400 Millivolt für Phasendifferenz gleich null und 600 Millivolt für nacheilend; charakteristisch für binäre Phasendetektoren ist, dass die Höhe der Ausgangsspannung keine Information über die aktuelle Phasendifferenz an den Eingängen des Phasendetektors liefert - es wird nur unterschieden zwischen Phasendifferenz kleiner null, Phasendifferenz gleich null, Phasendifferenz größer null.

CDR-Schaltungen mit binären Phasendetektoren werden häufig bei Datenübertragungen im Frequenzbereich größer als ein Gigahertz eingesetzt, denn sie sind bei begrenzter Geschwindigkeit der verwendeten Technologie einfacher zu implementieren und zeigen ein sehr robustes Verhalten (bessere sogenannte Power-Supply-Rejection).

Des Weiteren ist es bei der Implementierung von CDR-Schaltungen üblich, dass ein spannungsgesteuerter Oszillator (= VCO = Voltage-Controlled Oscillator) mit zwei Tuning-Eingängen eingesetzt wird, um im benötigten Schleifenfilter der CDR-Schaltung kleinere on-chip-Kapazitäten zu implementieren und des Weiteren das Phasenrauschen der CDR-Schaltung zu verbessern.

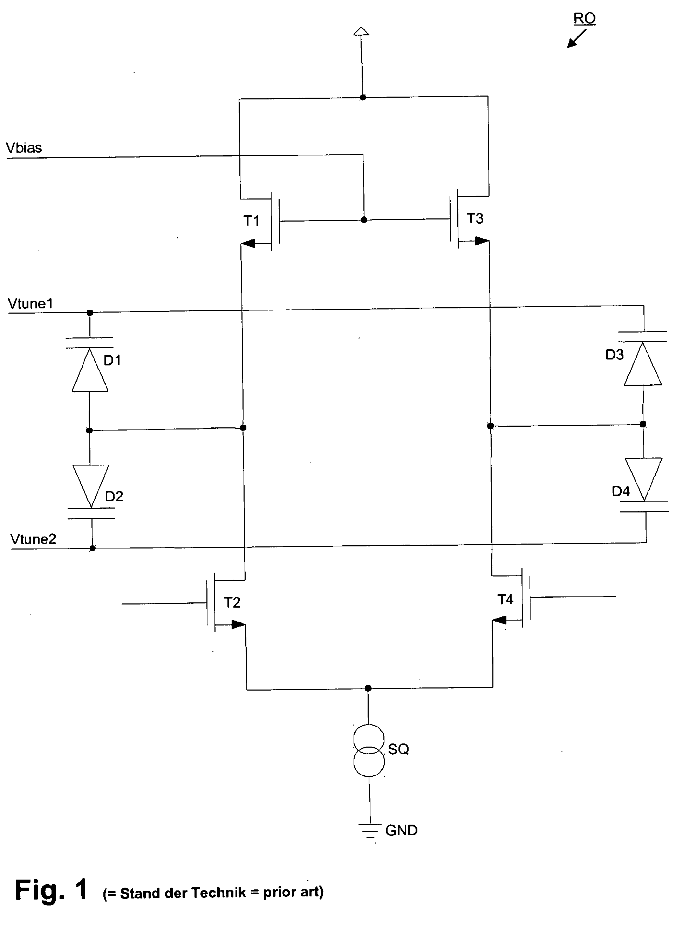

Fig. 1 zeigt ein erstes Beispiel für einen spannungsgesteuerten Ringoszillator RO mit zwei Tuning-Eingängen Vtune1, Vtune2 aus dem Stand der Technik. Die Frequenz dieses spannungsgesteuerten Oszillators RO kann über diese beiden Tuning-Eingänge Vtune1 und Vtune2 separat eingestellt werden. Hierbei wird die Frequenzänderung durch vier separate Varaktor(diod)en D1, D2, D3, D4 eingestellt.

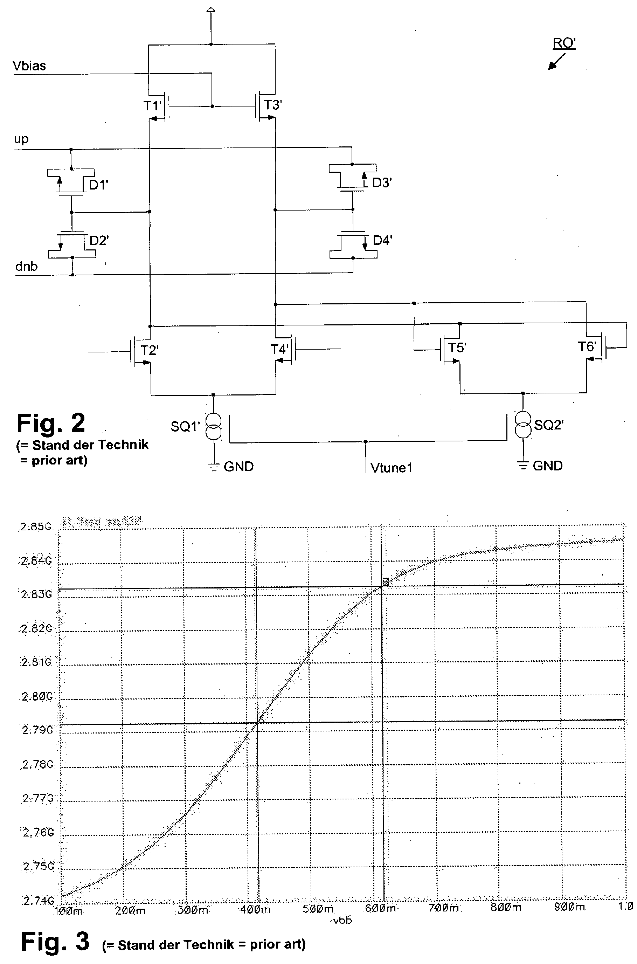

Fig. 2 zeigt ein zweites Beispiel für einen spannungsgesteuerten Ringoszillator RO' mit zwei Tuning-Eingängen Vtune1, Vtune2 aus dem Stand der Technik. Mittels des ersten Tuning-Eingangs Vtune1 wird üblicherweise eine Grobeinstellung des spannungsgesteuerten Oszillators RO' vorgenommen, wobei sich die Stromstärke 11 einer ersten Stromquelle SQ1' zu 11 = I_{D[irect]C[urrent]} + Leitwert* Vtune1 und die Stromstärke 12 einer zweiten Stromquelle SQ2' zu 12 = I_{D[irect]C[urrent]} - Leitwert* Vtune1 ergeben.

Mit den beiden digitalen Signalen up und dnb wird eine Feineinstellung des spannungsgesteuerten Oszillators RO' vorgenommen. up und dnb können die digitalen Ausgangssignale eines binären Phasendetektors sein.

Fig. 3 zeigt den Frequenz-Tuning-Bereich des spannungsgesteuerten Oszillators RO' aus Fig. 2, wenn zum Beispiel die Spannung an up oder an dnb von 100 Millivolt bis ein Volt verändert wird (= Rechtsachse). Da die beiden Tuningsignale up und dnb üblicherweise digitaler Natur sind, hat der Oszillator RO' drei unterschiedliche Ausgangsfrequenzen:
up = 0, dnb = 1: Ausgangsfrequenz f0;
up = 1, dnb = 1: Ausgangsfrequenz f0 - df;
up = 1, dnb = 0: Ausgangsfrequenz f0;
up = 0, dnb = 0: Ausgangsfrequenz f0 + df.

Die Nachteile der gemäß den beiden Beispielen der Fig. 1 bis Fig. 3 beschriebenen konventionellen Lösungen sind zum einen ein hoher Energieverbrauch wegen der Erzeugung zweier digitaler Signale up und dnb, zum anderen eine niedrige Ausgangsfrequenz, denn es sind vier Varaktoren D1, D2, D3, D4 (vgl. erstes Beispiel gemäß Fig. 1) bzw. D1', D2', D3', D4' (vgl. zweites Beispiel gemäß Fig. 2 und Fig. 3) erforderlich, so dass mehr parasitäre Kapazität im Oszillators RO bzw. Oszillators RO' erzeugt wird.

Die Druckschrift US 7 129 763 B1 offenbart einen digitalen Schaltungsaufbau für ein Rechengerät; insbesondere offenbart die US 7 129 763 B1 ein Einstellen der Leistungsaufnahme des digitalen Schaltungsaufbaus durch Erzeugen eines Frequenzfehlers, der einen Fehler in einer Signalverzögerung darstellt. Mithin hat die US 7 129 763 B1 zum Ziel, in einer digitalen Schaltung die Leistungsaufnahme zu senken. Als Maß dienen interne Signalverzögerungen der Schaltung, die in akzeptablen Grenzen bleiben müssen.

Zum technologischen Hintergrund der vorliegenden Erfindung wird auf die Druckschrift US 6 259 326 B1 sowie auf die Druckschrift EP 0 739 089 A2 aufmerksam gemacht.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung gemäß dem Oberbegriff des Anspruchs 1 sowie ein Verfahren gemäß dem Oberbegriff des Anspruchs 13 so weiterzubilden, dass der Energieaufwand möglichst gering und die Ausgangsfrequenz möglichst groß ist.

Diese Aufgabe wird durch eine Schaltungsanordnung mit den Merkmalen des Anspruchs 1 sowie durch ein Verfahren mit den Merkmalen des Anspruchs 13 gelöst. Vorteilhafte Ausgestaltungen und zweckmäßige Weiterbildungen der vorliegenden Erfindung sind in den jeweiligen Unteransprüchen gekennzeichnet.

Erfindungsgemäß wird mindestens ein spannungsgesteuerter Oszillator (= VCO = Voltage-Controlled Oscillator) für mindestens eine Schaltung zur Takt- und Datenrückgewinnung (= CDR = Clock and Data Recovery), die mindestens einen binären Phasendetektor (= sogenannten Bang-Bang-Phasendetektor oder Aufwärts/Abwärts-Phasendetektor) aufweist, derart angesteuert, dass nicht mehr vier, sondern nur noch zwei Varaktor(diod)en oder Abstimmdioden oder Kapazitätsdioden oder Varicaps benötigt werden, wobei die Frequenzänderung nicht mehr mit zwei Ansteuersignalen, sondern nur noch mit einem Ansteuersignal erzielt wird.

Hierdurch ist zum einen ein niedriger Strombedarf, das heißt ein niedriger Energieverbrauch realisierbar, denn aufgrund geringerer Parasitär-Kapazität als im Stand der Technik ist weniger Strom erforderlich, um die gleiche Ausgangsfrequenz zu erzielen. Zum anderen ist eine höhere Ausgangsfrequenz realisierbar, denn durch lediglich zwei Varaktoren (anstelle vierer Varaktoren im Stand der Technik) wird weniger parasitäre Kapazität im spannungsgesteuerten Oszillator erzeugt, so dass das Layout des spannungsgesteuerten Oszillators kompakter gestaltet werden kann.

Die vorliegende Erfindung betrifft schließlich die Verwendung mindestens einer Schaltungsanordnung gemäß der vorstehend dargelegten Art und/oder eines Verfahrens gemäß der vorstehend dargelegten Art zum Ansteuern mindestens eines spannungsgesteuerten Oszillators (= VCO = Voltage-Controlled Oscillator) für mindestens eine Schaltung zur Takt- und Datenrückgewinnung (= CDR = Clock and Data Recovery) mit mindestens einem binären Phasendetektor (= sogenannter Bang-Bang-Phasendetektor oder Aufwärts/Abwärts-Phasendetektor).

### Kurze Beschreibung der Zeichnungen

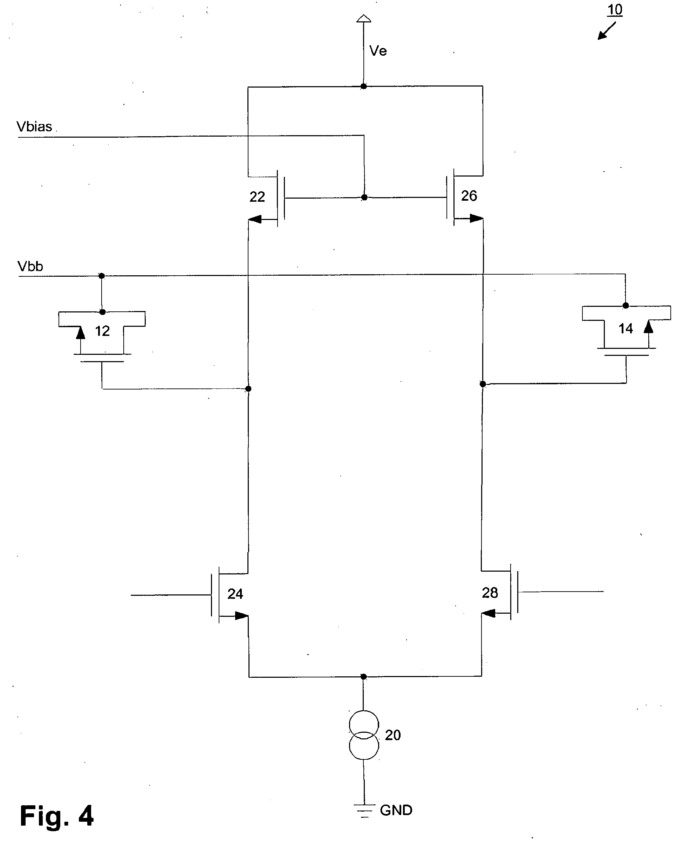

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch 13 nachgeordneten Ansprüche verwiesen, andererseits werden weitere Ausgestaltungen, Merkmale und Vorteile der vorliegenden Erfindung nachstehend unter Anderem anhand des durch Fig. 4 bis Fig. 10 veranschaulichten Ausführungsbeispiels näher erläutert. Es zeigt:
- Fig. 1: in konzeptuell-schematischer Darstellung ein erstes Beispiel für einen spannungsgesteuerten Oszillator aus dem Stand der Technik, der nach dem Verfahren aus dem Stand der Technik arbeitet;
- Fig. 2: in konzeptuell-schematischer Darstellung ein zweites Beispiel für einen spannungsgesteuerten Oszillator aus dem Stand der Technik, der nach dem Verfahren aus dem Stand der Technik arbeitet;
- Fig.3: in diagrammatischer Darstellung die typische Frequenz-Tuning-Charakteristik des spannungsgesteuerten Oszillators aus Fig. 2, wobei die Ansteuerspannung auf der Rechtsachse aufgetragen ist;

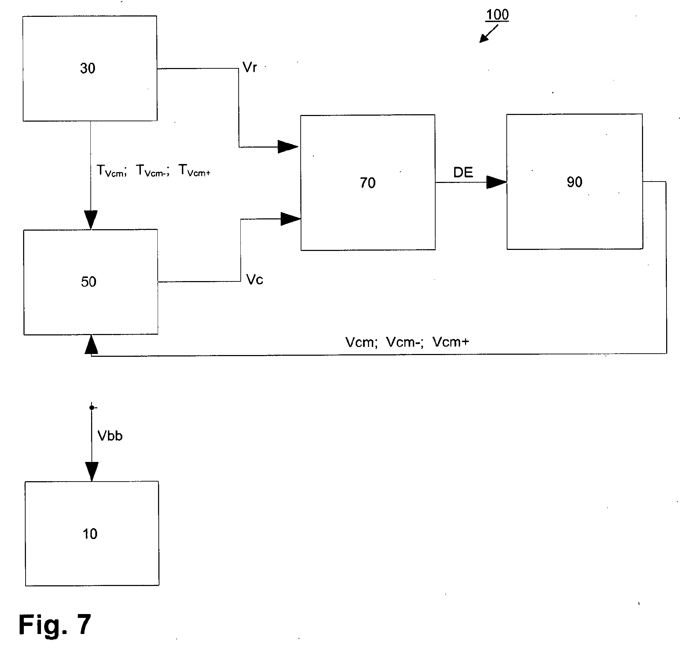

- Fig. 4: in konzeptuell-schematischer Darstellung ein Ausführungsbeispiel für einen spannungsgesteuerten Oszillator, der Teil der erfindungsgemäßen Schaltungsanordnung aus Fig. 7 ist und nach dem Verfahren gemäß der vorliegenden Erfindung arbeitet;

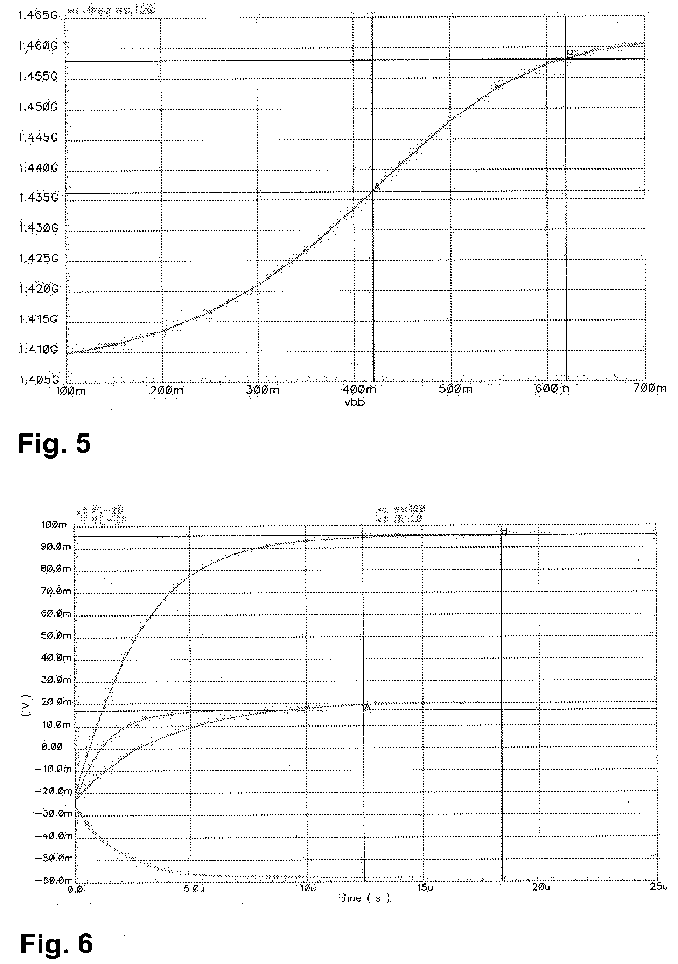

- Fig. 5: in diagrammatischer Darstellung die Frequenz-Tuning-Charakteristik des spannungsgesteuerten Oszillators aus Fig. 4, wobei die Ansteuerspannung auf der Rechtsachse aufgetragen ist;
- Fig. 6: in diagrammatischer Darstellung betriebsparameterbedingte Abweichungen in der Frequenz-Tuning-Charakteristik aus Fig. 5;
- Fig. 7: in konzeptuell-schematischer Darstellung ein Ausführungsbeispiel für eine Schaltungsanordnung gemäß der vorliegenden Erfindung, die nach dem Verfahren gemäß der vorliegenden Erfindung arbeitet;

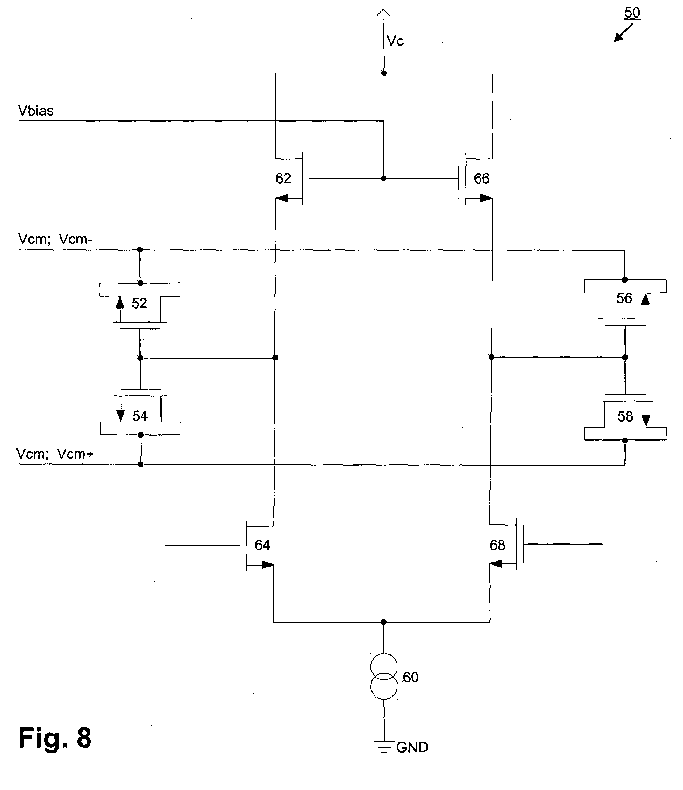

- Fig.8: in konzeptuell-schematischer Darstellung ein Ausführungsbeispiel für einen Kalibrierungsoszillator, der Teil der erfindungsgemäßen Schaltungsanordnung aus Fig. 7 ist und nach dem Verfahren gemäß der vorliegenden Erfindung arbeitet;

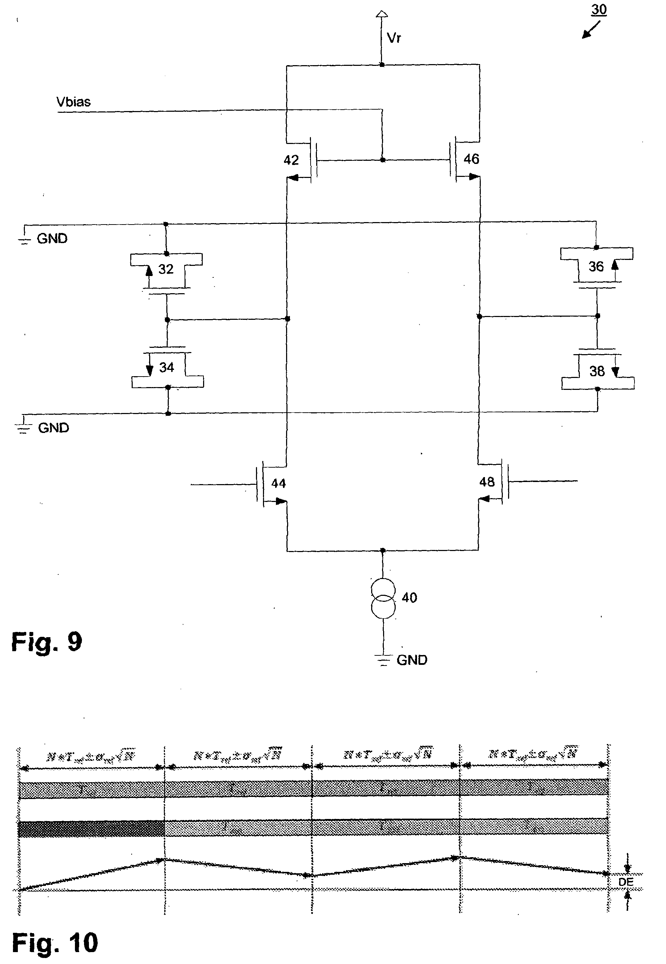

- Fig. 9: in konzeptuell-schematischer Darstellung ein Ausführungsbeispiel für einen Referenzoszillator, der Teil der erfindungsgemäßen Schaltungsanordnung aus Fig. 7 ist und nach dem Verfahren gemäß der vorliegenden Erfindung arbeitet; und
- Fig. 10: in diagrammatischer Darstellung eine visuelle Veranschaulichung der Berechnungen der Schaltungsanordnung aus Fig. 7.

Gleiche oder ähnliche Ausgestaltungen, Elemente oder Merkmale sind in Fig. 1 bis Fig. 10 mit identischen Bezugszeichen versehen.

### Bester Weg zur Ausführung der vorliegenden Erfindung

Fig. 4 zeigt ein Ausführungsbeispiel für einen spannungsgesteuerten Ringoszillator 10. Die Frequenz dieses spannungsgesteuerten Oszillators 10 kann - anders als im Stand der Technik (vgl. Fig. 1, Fig. 2), demzufolge zwei Tuning-Eingänge benötigt werden - über ein kalibriertes Ansteuersignal Vbb eingestellt werden. Hierbei wird die Frequenzänderung durch zwei Varaktor(diod)en oder Abstimmdioden oder Kapazitätsdioden oder Varicaps 12, 14 eingestellt.

Fig. 4 ist entnehmbar, dass der anodische Anschluss des ersten Varaktors 12 des spannungsgesteuerten Oszillators 10 und der anodische Anschluss des zweiten Varaktors 14 des spannungsgesteuerten Oszillators 10 mit dem kalibrierten Ansteuersignal Vbb beaufschlagt werden.

Der kathodische Anschluss des ersten Varaktors 12 ist mit dem Sourcekontakt oder Emitteranschluss eines ersten Transistors 22 des spannungsgesteuerten Oszillators 10 sowie mit dem Drainkontakt oder Kollektoranschluss eines zweiten Transistors 24 des spannungsgesteuerten Oszillators 10 verbunden, und der kathodische Anschluss des zweiten Varaktors 14 ist mit dem Sourcekontakt oder Emitteranschluss eines dritten Transistors 26 des spannungsgesteuerten Oszillators 10 sowie mit dem Drainkontakt oder Kollektoranschluss eines vierten Transistors 28 des spannungsgesteuerten Oszillators 10 verbunden.

Der Sourcekontakt oder Emitteranschluss des zweiten Transistors 24 und der Sourcekontakt oder Emitteranschluss des vierten Transistors 28 sind miteinander sowie mit einer Stromquelle 20 verbunden. Der Gatekontakt oder Basisanschluss des ersten Transistors 22 und der Gatekontakt oder Basisanschluss des dritten Transistors 26 sind miteinander verbunden und werden mit einer Biasspannung oder Vorspannung Vbias beaufschlagt. Der Drainkontakt oder Kollektoranschluss des ersten Transistors 22 und der Drainkontakt oder Kollektoranschluss des dritten Transistors 26 stellen das Ausgangssignal Ve des spannungsgesteuerten Oszillators 10 zur Verfügung.

Fig. 5 zeigt die typische Frequenz-Tuning-Charakteristik, wenn die Ansteuerspannung Vbb im Bereich von 100 Millivolt bis 700 Millivolt variiert wird. Der Oszillator 10 erhält am Tuning-Eingang Vbb nun drei diskrete, entsprechend vom Ausgang des binären Phasendetektors erzeugte Spannungen und erzeugt damit nun drei diskrete Ausgangsfrequenzen:
- Tuningspannung Vbb = 200 Millivolt --> Ausgangsfrequenz f0 - df;
- Tuningspannung Vbb = 400 Millivolt --> Ausgangsfrequenz f0;
- Tuningspannung Vbb = 600 Millivolt --> Ausgangsfrequenz f0 + df.

Die Frequenz-Tuning-Charakteristik ändert sich über die Betriebsparameter, wie etwa Technologie, Versorgungsspannung und Temperatur. Dieses Verhalten ist in Fig. 6 dargestellt, in der zum optimalen Einstellen der Ausgangsfrequenz f0 eine Ansteuerspannung Vbb von etwa 495 Millivolt anstelle 400 Millivolt angezeigt ist, das heißt die Abweichung von Vbb = 400 Millivolt beträgt zum Beispiel für eine Chip-Temperatur von 120 Grad Celsius etwa 95 Millivolt.

Um nun für alle Betriebsparameter jeweils die korrekte Tuningspannung Vbb zu erzeugen, weist die vorliegende Erfindung eine Kalibrierungsschaltung 100 auf, wie anhand eines Ausführungsbeispiels in Fig. 7 veranschaulicht:

Die Kalibrierungsschaltung 100 gemäß Fig. 7 weist zwei zusätzliche Oszillatoren 30, 50 von im Wesentlichen gleicher Bauart wie den vorstehend unter Bezugnahme auf Fig. 4 beschriebenen Hauptoszillator 10 auf. Jedoch können diese beiden zusätzlichen Oszillatoren 30, 50 mit wesentlich niedrigerer Frequenz und damit mit wesentlich niedrigerem Stromverbrauch als der Hauptoszillator 10 betrieben werden; gleichwohl weisen diese beiden zusätzlichen Oszillatoren 30, 50 im Wesentlichen die gleichen Tuning-Eigenschaften wie der Hauptoszillator 10 auf.

Der eine der beiden zusätzlichen Oszillatoren 30, 50 ist ein anhand Fig. 8 exemplarisch veranschaulichter Kalibrierungsoszillator 50, der jeweils abwechselnd für die Zeitspanne Tref eine erste Tuningspannung Vcm von etwa 400 Millivolt, anschließend eine dritte Tuningspannung Vcm+ von etwa 600 Millivolt (= Vcm + 200 Millivolt) und daran anschließend eine zweite Tuningspannung Vcm- von etwa 200 Millivolt (= Vcm - 200 Millivolt) erhält.

Der anodische Anschluss eines ersten Varaktors 52 des Kalibrierungsoszillators 50 wird mit der ersten Tuningspannung Vcm und mit der zweiten Tuningspannung Vcm- beaufschlagt, und der anodische Anschluss eines zweiten Varaktors 54 des Kalibrierungsoszillators 50 wird mit der ersten Tuningspannung Vcm und mit der dritten Tuningspannung Vcm+ beaufschlagt.

Der kathodische Anschluss des ersten Varaktors 52 und der kathodische Anschluss des zweiten Varaktors 54 sind miteinander, mit dem Sourcekontakt oder Emitteranschluss eines ersten Transistors 62 des Kalibrierungsoszillators 50 sowie mit dem Drainkontakt oder Kollektoranschluss eines zweiten Transistors 64 des Kalibrierungsoszillators 50 verbunden.

Der anodische Anschluss eines dritten Varaktors 56 des Kalibrierungsoszillators 50 wird mit der ersten Tuningspannung Vcm und mit der zweiten Tuningspannung Vcm- beaufschlagt, und der anodische Anschluss eines vierten Varaktors 58 des Kalibrierungsoszillators 50 wird mit der ersten Tuningspannung Vcm und mit der dritten Tuningspannung Vcm+ beaufschlagt.

Der kathodische Anschluss des dritten Varaktors 56 und der kathodische Anschluss des vierten Varaktors 58 sind miteinander, mit dem Sourcekontakt oder Emitteranschluss eines dritten Transistors 66 des Kalibrierungsoszillators 50 sowie mit dem Drainkontakt oder Kollektoranschluss eines vierten Transistors 68 des Kalibrierungsoszillators 50 verbunden.

Der Sourcekontakt oder Emitteranschluss des zweiten Transistors 64 und der Sourcekontakt oder Emitteranschluss des vierten Transistors 68 sind miteinander sowie mit einer Stromquelle 60 verbunden. Der Gatekontakt oder Basisanschluss des ersten Transistors 62 und der Gatekontakt oder Basisanschluss des dritten Transistors 66 sind miteinander verbunden und werden mit einer Biasspannung oder Vorspannung Vbias beaufschlagt. Der Draihkontakt oder Kollektoranschluss des ersten Transistors 62 und der Drainkontakt oder Kollektoranschluss des dritten Transistors 66 stellen das Ausgangssignal Vc des Kalibrierungsoszillators 50 zur Verfügung.

Der anderen der beiden zusätzlichen Oszillatoren 30, 50 ist ein anhand Fig. 9 exemplarisch veranschaulichter Referenzoszillator 30, der dem Kalibrierungsoszillator 50 taktmäßig zugeordnet ist.

Der anodische Anschluss eines ersten Varaktors 32 des Referenzoszillators 30 und der anodische Anschluss eines zweiten Varaktors 34 des Referenzoszillators 30 werden mit einem Bezugspotential oder Referenzpotential GND, nämlich mit Erdpotential oder Massepotential oder Nullpotential beaufschlagt.

Der kathodische Anschluss des ersten Varaktors 32 und der kathodische Anschluss des zweiten Varaktors 34 sind miteinander, mit dem Sourcekontakt oder Emitteranschluss eines ersten Transistors 42 des Referenzoszillators 30 sowie mit dem Drainkontakt oder Kollektoranschluss eines zweiten Transistors 44 des Referenzoszillators 30 verbunden.

Der anodische Anschluss eines dritten Varaktors 36 des Referenzoszillators 30 und der anodische Anschluss eines vierten Varaktors 38 des Referenzoszillators 30 werden mit dem Bezugspotential oder Referenzpotential GND, nämlich mit Erdpotential oder Massepotential oder Nullpotential beaufschlagt.

Der kathodische Anschluss des dritten Varaktors 36 und der kathodische Anschluss des vierten Varaktors 38 sind miteinander, mit dem Sourcekontakt oder Emitteranschluss eines dritten Transistors 46 des Referenzoszillators 30 sowie mit dem Drainkontakt oder Kollektoranschluss eines vierten Transistors 48 des Referenzoszillators 30 verbunden.

Der Sourcekontakt oder Emitteranschluss des zweiten Transistors 44 und der Sourcekontakt oder Emitteranschluss des vierten Transistors 48 sind miteinander sowie mit einer Stromquelle 40 verbunden. Der Gatekontakt oder Basisanschluss des ersten Transistors 42 und der Gatekontakt oder Basisanschluss des dritten Transistors 46 sind miteinander verbunden und werden mit einer Biasspannung oder Vorspannung Vbias beaufschlagt. Der Drainkontakt oder Kollektoranschluss des ersten Transistors 42 und der Drainkontakt oder Kollektoranschluss des dritten Transistors 46 stellen das Ausgangssignal Vr des Referenzoszillators 30 zur Verfügung.

Bei den vorgenannten Varaktor(diod)en oder Abstimmdioden oder Kapazitätsdioden oder Varicaps 12, 14, 32, 34, 36, 38, 52, 54, 56, 58 handelt es sich um elektronische Halbleiterbauteile, bei denen sich durch Ändern der angelegten Spannung eine Variation der Kapazität von zum Beispiel 10 zu 1 erreichen lässt, so dass eine elektrisch steuerbare Kapazität zur Verfügung steht.

Ein Teil der vorgenannten Transistoren 22, 24, 26, 28, 42, 44, 46, 48, 62, 64, 66, 68 kann oder alle vorgenannten Transistoren 22, 24, 26, 28, 42, 44, 46, 48, 62, 64, 66, 68 können insbesondere als Feldeffekttransistoren (FET = Field-Effect Transistor), zum Beispiel als Metall-Oxid-Halbleiter-Feldeffekttransistoren (MOSFET = Metal-Oxide-Semiconductor Field-Effect Transistor), wie etwa als n-Typ-Metall-Oxid-Halbleiter-Feldeffekttransistoren (n-type MOSFETs), ausgebildet sein.

Ein dem Kalibrierungsoszillator 50 sowie dem Referenzoszillator 30 nachgeschalteter Taktzähler 70 (sogenannter clock cycle error counter) vergleicht auf Basis des Ausgangssignals Vc des Kalibrierungsoszillators 50 sowie des Ausgangssignals Vr des Referenzoszillators 30 die jeweilige Anzahl N der Takte (sogenannte clock cycles) des Kalibrierungsoszillators 50 bzw. des Referenzoszillators 30 und bildet die Differenz.

Der sich aus der Differenz dieser beiden Taktanzahlen N ergebende Taktfehler DE (sogenannter clock cycle error) wird im Taktzähler 70 integriert und als digitales Bus-Signal einem dem Taktzähler 70 nachfolgenden Digital-Analog-Wandler 90 als Eingangssignal bereit gestellt. Der Digital-Analog-Wandler 90 wandelt den Taktfehler DE in ein analoges Signal um, das die Tuningspannung Vcm, Vcm-, Vcm+ im Kalibrierungsoszillator 50 auf den richtigen Wert einstellt.

Fig. 10 veranschaulicht exemplarisch die Berechnungen der Kalibrierungsschaltung 100, insbesondere Genauigkeit, Standardabweichung σ, notwendige Zählerlänge des Taktzählers 70, Bitbreite des Digital-Analog-Wandlers 90 und dergleichen.

### Hierbei

- ist in der obersten Zeile der Fig. 10 die jeweils durch einen Doppelpfeil angedeutete zeitliche Signallänge N*T_{ref}± σ_{ref}*N^{0,5} veranschaulicht,
- in der zweitobersten Zeile wird die Funktion des N Zyklen zählenden Referenzoszillators 30 veranschaulicht,
- in der zweituntersten Zeile wird die Funktion des die Frequenz verschiebenden Kalibrierungsoszillators 50 veranschaulicht und
- in der untersten Zeile wird die Funktion des digitalen Integrierers innerhalb des Taktzählers 70 veranschaulicht.

Hierbei ergibt sich die Anzahl N_{count@600} der clock cycles (Takte) während der Tuningspannung Vcm + 200 Millivolt (= etwa 600 Millivolt) zu N_{count@600} = [N*T_{ref} ± σ_{ref}*N^{0,5} ± σ₆₀₀*(N*T_{ref}/T₆₀₀)^{0,5}]T₆₀₀; entsprechend ergibt sich die Anzahl N_{count@400} der clock cycles (Takte) während der Tuningspannung Vcm (= etwa 400 Millivolt) zu N_{count@400} = [N*T_{ref} 2 ± σ_{ref}*N^{0,5} ±σ₄₀₀*(N*T_{ref}/T₄₀₀)^{0,5}]/T₄₀₀, und die Anzahl N_{count@200} der clock cycles (Takte) während der Tuningspannung Vcm - 200 Millivolt (= etwa 200 Millivolt) ergibt sich zu N_{count@200} = [N*T_{ref} ± σ_{ref}*N^{0,5} ± σ₂₀₀*(N*T_{ref}/T₂₀₀)^{0,5}]/T₂₀₀.

Wenn der Referenzoszillator 30 von derselben Art wie der Kalibrierungsoszillator 50 ist, so ist auch die Jitter-Performance dieselbe, so dass in obiger Formel σ₆₀₀*(N*T_{ref}/T₆₀₀)^{0,5} = σ_{ref}*N^{0,5} bzw. σ₄₀₀*(N*T_{ref}/T₄₀₀)^{0,5} = σ_{ref}*N^{0,5} bzw. σ₂₀₀*(N*T_{ref}/T₂₀₀)^{0,5} = σ_{ref}*N^{0,5} gilt.

In diesem Falle ergibt sich die Anzahl N_{count@600} der clock cycles (Takte) während der Tuningspannung Vcm + 200 Millivolt (= etwa 600 Millivolt) zu Anzahl N_{count@600} = [N*T_{ref} ± 2*σ_{ref}*N^{0,5}]/T₆₀₀; entsprechend ergibt sich die Anzahl N_{count@400} der clock cycles (Takte) während der Tuningspannung Vcm (= etwa 400 Millivolt) zu Anzahl N_{count@400} = [N*T_{ref} ± 2*σ_{ref}*N^{0,5}]/T₄₀₀, und die Anzahl N_{count@200} der clock cycles (Takte) während der Tuningspannung Vcm - 200 Millivolt (= etwa 200 Millivolt) ergibt sich zu zu Anzahl N_{count@200} = [N*T_{ref} ± 2*σ_{ref}*N^{0,5}]/T₂₀₀.

Der digitale Integrierer innerhalb des Taktzählers 70 gibt unter Berücksichtigung des digitalen Fehlers DE die Gesamtanzahl N_{count@600} - N_{count@400} + N_{count@200} - N_{count@400} = [N*T_{ref} ± 2*σ_{ref}*N^{0,5}]/T₆₀₀ - [N*T_{ref} ± 2*σ_{ref}*N^{0,5}]/T₄₀₀ + [N*T_{ref} ± 2*σ_{ref}*N^{0,5}]/T₂₀₀ - [N*T_{ref} ± 2*σ_{ref}*N^{0,5}]/T₄₀₀ aus.

Da nun ± 2*σ_{ref}*N^{0,5}]/T₆₀₀ ± 2*σ_{ref}*N^{0,5}]/T₄₀₀ ± 2*σ_{ref}*N^{0,5}]/T₂₀₀ ± 2*σ_{ref}*N^{0,5}]/T₄₀₀ = ± 8*σ_{ref}*N^{0,5}]/T₄₀₀, ergibt sich eine Frequenzabweichung Δf₆₀₀₋₄₀₀ - Δf₄₀₀₋₂₀₀ = 1/T₆₀₀ - 1/T₄₀₀ - (1/T₄₀₀ - 1/T₂₀₀) = 1/T₆₀₀ - 1/T₄₀₀ + 1/T₂₀₀ - 1/T₄₀₀ = ± 8*σ_{ref}/T_{ref}*T₄₀₀*N^{0,5}).

### Bezugszeichenliste

- 100: Schaltungsanordnung, insbesondere Kalibrierungsschaltung
- 10: spannungsgesteuerter Oszillator, insbesondere spannungsgesteuerter Ringoszillator
- 12: erster Varaktor des spannungsgesteuerten Oszillators 10
- 14: zweiter Varaktor des spannungsgesteuerten Oszillators 10
- 20: Stromquelle des spannungsgesteuerten Oszillators 10
- 22: erster Transistor des spannungsgesteuerten Oszillators 10
- 24: zweiter Transistor des spannungsgesteuerten Oszillators 10
- 26: dritter Transistor des spannungsgesteuerten Oszillators 10
- 28: vierter Transistor des spannungsgesteuerten Oszillators 10
- 30: Referenzoszillator
- 32: erster Varaktor des Referenzoszillators 30
- 34: zweiter Varaktor des Referenzoszillators 30
- 36: dritter Varaktor des Referenzoszillators 30
- 38: vierter Varaktor des Referenzoszillators 30
- 40: Stromquelle des Referenzoszillators 30
- 42: erster Transistor des Referenzoszillators 30
- 44: zweiter Transistor des Referenzoszillators 30
- 46: dritter Transistor des Referenzoszillators 30
- 48: vierter Transistor des Referenzoszillators 30
- 50: Kalibrierungsoszillator
- 52: erster Varaktor des Kalibrierungsoszillators 50
- 54: zweiter Varaktor des Kalibrierungsoszillators 50
- 56: dritter Varaktor des Kalibrierungsoszillators 50
- 58: vierter Varaktor des Kalibrierungsoszillators 50
- 60: Stromquelle des Kalibrierungsoszillators 50
- 62: erster Transistor des Kalibrierungsoszillators 50
- 64: zweiter Transistor des Kalibrierungsoszillators 50
- 66: dritter Transistor des Kalibrierungsoszillators 50
- 68: vierter Transistor des Kalibrierungsoszillators 50
- 70: Taktzähler
- 90: Digital-Analog-Wandler
- D1: erster Varaktor des spannungsgesteuerten Oszillators RO (= Stand der Technik; vgl. Fig. 1)
- D1': erster Varaktor des spannungsgesteuerten Oszillators RO' (= Stand der Technik; vgl. Fig. 2)
- D2: zweiter Varaktor des spannungsgesteuerten Oszillators RO (= Stand der Technik; vgl. Fig. 1)
- D2': zweiter Varaktor des spannungsgesteuerten Oszillators RO' (= Stand der Technik; vgl. Fig. 2)
- D3: dritter Varaktor des spannungsgesteuerten Oszillators RO (= Stand der Technik; vgl. Fig. 1)
- D3': dritter Varaktor des spannungsgesteuerten Oszillators RO' (= Stand der Technik; vgl. Fig. 2)
- D4: vierter Varaktor des spannungsgesteuerten Oszillators RO (= Stand der Technik; vgl. Fig. 1)
- D4': vierter Varaktor des spannungsgesteuerten Oszillators RO' (= Stand der Technik; vgl. Fig. 2)
- DE: Taktfehler, insbesondere digitaler Taktfehler
- dnb: zweites digitales Signal zur Feineinstellung des spannungsgesteuerten Oszillators RO' (= Stand der Technik; vgl. Fig. 2)
- GND: Bezugspotential oder Referenzpotential, insbesondere Erdpotential oder Massepotential oder Nullpotential
- I1: Stromstärke der ersten Stromquelle SQ1' (= Stand der Technik; vgl. Fig. 2)
- I2: Stromstärke der zweiten Stromquelle SQ2' (= Stand der Technik; vgl. Fig. 2)
- N: Taktanzahl
- RO: spannungsgesteuerter Oszillator, insbesondere spannungsgesteuerter Ringoszillator (= Stand der Technik; vgl. Fig. 1)
- RO': spannungsgesteuerter Oszillator, insbesondere spannungsgesteuerter Ringoszillator (= Stand der Technik; vgl. Fig. 2)
- SQ: Stromquelle des spannungsgesteuerten Oszillators RO (= Stand der Technik; vgl. Fig. 1)
- SQ1': erste Stromquelle des spannungsgesteuerten Oszillators RO' (= Stand der Technik; vgl. Fig. 2)
- SQ2': zweite Stromquelle des spannungsgesteuerten Oszillators RO' (= Stand der Technik; vgl. Fig. 2)
- Tref: Zeit oder Zeitspanne
- T1: erster Transistor des spannungsgesteuerten Oszillators RO (= Stand der Technik; vgl. Fig. 1)
- T1': erster Transistor des spannungsgesteuerten Oszillators RO' (= Stand der Technik; vgl. Fig. 2)
- T2: zweiter Transistor des spannungsgesteuerten Oszillators RO (= Stand der Technik; vgl. Fig. 1)
- T2': zweiter Transistor des spannungsgesteuerten Oszillators RO' (= Stand der Technik; vgl. Fig. 2)
- T3: dritter Transistor des spannungsgesteuerten Oszillators RO (= Stand der Technik; vgl. Fig. 1)
- T3': dritter Transistor des spannungsgesteuerten Oszillators RO' (= Stand der Technik; vgl. Fig. 2)
- T4: vierter Transistor des spannungsgesteuerten Oszillators RO (= Stand der Technik; vgl. Fig. 1)
- T4': vierter Transistor des spannungsgesteuerten Oszillators RO' (= Stand der Technik; vgl. Fig. 2)
- T5': fünfter Transistor des spannungsgesteuerten Oszillators RO' (= Stand der Technik; vgl. Fig. 2)
- T6': sechster Transistor des spannungsgesteuerten Oszillators RO' (= Stand der Technik; vgl. Fig. 2)
- up: erstes digitales Signal zur Feineinstellung des spannungsgesteuerten Oszillators RO' (= Stand der Technik; vgl. Fig. 2)
- Vbb: Ansteuersignal des spannungsgesteuerten Oszillators 10
- Vbias: Biasspannung oder Vorspannung
- Vc: Ausgangssignal des Kalibrierungsoszillators 50
- Vcm: erstes Tuningsignal des Kalibrierungsoszillators 50
- Vcm-: zweites Tuningsignal des Kalibrierungsoszillators 50
- Vcm+: drittes Tuningsignal des Kalibrierungsoszillators 50
- Ve: Ausgangssignal des spannungsgesteuerten Oszillators 10
- Vr: Ausgangssignal des Referenzoszillators 30
- Vtune1: erster Tuning-Eingang (= Stand der Technik; vgl. Fig. 1 und Fig. 2)
- Vtune2: zweiter Tuning-Eingang (= Stand der Technik; vgl. Fig. 1)

## Patentansprüche

1. Schaltungsanordnung (100) zum Kalibrieren mindestens eines für einen spannungsgesteuerten Oszillator (10) vorgesehenen Ansteuersignals (Vbb),
**gekennzeichnet durch**
- mindestens einen Kalibrierungsoszillator (50),
- mindestens einen dem Kalibrierungsoszillator (50) zugeordneten Referenzoszillator (30),
- mindestens einen dem Kalibrierungsoszillator (50) und dem Referenzoszillator (30) nachgeschalteten Taktzähler (70) zum Zählen der jeweiligen Taktanzahl (N) des Kalibrierungsoszillators (50) und des Referenzoszillators (30) sowie zum Integrieren eines sich aus der Differenz dieser beiden Taktanzahlen (N) ergebenden Taktfehlers (DE) und
- mindestens einen dem Taktzähler (70) nachgeschalteten Digital-Analog-Wandler (90) zum Wandeln des Taktfehlers (DE) in analoge Tuningsignale (Vcm, Vcm-, Vcm+), aus denen das kalibrierte Ansteuersignal (Vbb) ableitbar ist.

2. Schaltungsanordnung gemäß Anspruch 1, **dadurch gekennzeichnet, dass** der spannungsgesteuerte Oszillator (10) aufweist:
- einen ersten Varaktor (12), dessen kathodischer Anschluss mit dem Sourcekontakt oder Emitteranschluss eines ersten Transistors (22) sowie mit dem Drainkontakt oder Kollektoranschluss eines zweiten Transistors (24) verbunden ist, und
- einen zweiten Varaktor (14), dessen kathodischer Anschluss mit dem Sourcekontakt oder Emitteranschluss eines dritten Transistors (26) sowie mit dem Drainkontakt oder Kollektoranschluss eines vierten Transistors (28) verbunden ist.

3. Schaltungsanordnung gemäß Anspruch 2, **dadurch gekennzeichnet, dass** der Sourcekontakt oder Emitteranschluss des zweiten Transistors (24) und der Sourcekontakt oder Emitteranschluss des vierten Transistors (28) miteinander sowie mit mindestens einer Stromquelle (20) verbunden sind.

4. Schaltungsanordnung gemäß Anspruch 2 oder 3, **dadurch gekennzeichnet,**
- **dass** der Gatekontakt oder Basisanschluss des ersten Transistors (22) und der Gatekontakt oder Basisanschluss des dritten Transistors (26) miteinander verbunden sowie mit einer Biasspannung oder Vorspannung (Vbias) beaufschlagbar sind und
- **dass** der Drainkontakt oder Kollektoranschluss des ersten Transistors (22) und der Drainkontakt oder Kollektoranschluss des dritten Transistors (26) das Ausgangssignal (Ve) des spannungsgesteuerten Oszillators (10) zur Verfügung stellen.

5. Schaltungsanordnung gemäß mindestens einem der Ansprüche 2 bis 4, **dadurch gekennzeichnet, dass** der anodische Anschluss des ersten Varaktors (12) des spannungsgesteuerten Oszillators (10) und der anodische Anschluss des zweiten Varaktors (14) des spannungsgesteuerten Oszillators (10) mit dem kalibrierten Ansteuersignal (Vbb) beaufschlagbar sind.

6. Schaltungsanordnung gemäß mindestens einem der Ansprüche 1 bis 5, **dadurch gekennzeichnet, dass** der Referenzoszillator (30) aufweist:
- einen ersten Varaktor (32), dessen anodischer Anschluss mit einem Bezugspotential oder Referenzpotential (GND), insbesondere mit Erdpotential oder Massepotential oder Nullpotential, beaufschlagbar ist, sowie
- einen zweiten Varaktor (34), dessen anodischer Anschluss mit dem Bezugspotential oder Referenzpotential (GND) beaufschlagbar ist,
wobei der kathodische Anschluss des ersten Varaktors (32) und der kathodische Anschluss des zweiten Varaktors (34) miteinander, mit dem Sourcekontakt oder Emitteranschluss eines ersten Transistors (42) sowie mit dem Drainkontakt oder Kollektoranschluss eines zweiten Transistors (44) verbunden sind, und
- einen dritten Varaktor (36), dessen anodischer Anschluss mit dem Bezugspotential oder Referenzpotential (GND) beaufschlagbar ist, sowie
- einen vierten Varaktor (38), dessen anodischer Anschluss mit dem Bezugspotential oder Referenzpotential (GND) beaufschlagbar ist,
wobei der kathodische Anschluss des dritten Varaktors (36) und der kathodische Anschluss des vierten Varaktors (38) miteinander, mit dem Sourcekontakt oder Emitteranschluss eines dritten Transistors (46) sowie mit dem Drainkontakt oder Kollektoranschluss eines vierten Transistors (48) verbunden sind.

7. Schaltungsanordnung gemäß Anspruch 6, **dadurch gekennzeichnet, dass** der Sourcekontakt oder Emitteranschluss des zweiten Transistors (44) und der Sourcekontakt oder Emitteranschluss des vierten Transistors (48) miteinander sowie mit mindestens einer Stromquelle (40) verbunden sind.

8. Schaltungsanordnung gemäß Anspruch 6 oder 7, **dadurch gekennzeichnet,**
- **dass** der Gatekontakt oder Basisanschluss des ersten Transistors (42) und der Gatekontakt oder Basisanschluss des dritten Transistors (46) miteinander verbunden sowie mit einer Biasspannung oder Vorspannung (Vbias) beaufschlagbar sind und
- **dass** der Drainkontakt oder Kollektoranschluss des ersten Transistors (42) und der Drainkontakt oder Kollektoranschluss des dritten Transistors (46) das Ausgangssignal (Vr) des Referenzoszillators (30) zur Verfügung stellen.

9. Schaltungsanordnung gemäß mindestens einem der Ansprüche 1 bis 8, **dadurch gekennzeichnet, dass** der Kalibrierungsoszillator (50) aufweist:
- einen ersten Varaktor (52), dessen anodischer Anschluss mit einem ersten (Vcm) der Tuningsignale (Vcm, Vcm-, Vcm+) und mit einem zweiten (Vcm-) der Tuningsignale (Vcm, Vcm-, Vcm+) beaufschlagbar ist, sowie
- einen zweiten Varaktor (54), dessen anodischer Anschluss mit dem ersten Tuningsignal (Vcm) und mit einem dritten (Vcm+) der Tuningsignale (Vcm, Vcm-, Vcm+) beaufschlagbar ist,
wobei der kathodische Anschluss des ersten Varaktors (52) und der kathodische Anschluss des zweiten Varaktors (54) miteinander, mit dem Sourcekontakt oder Emitteranschluss eines ersten Transistors (62) sowie mit dem Drainkontakt oder Kollektoranschluss eines zweiten Transistors (64) verbunden sind, und
- einen dritten Varaktor (56), dessen anodischer Anschluss mit dem ersten Tuningsignal (Vcm) und mit dem zweiten Tuningsignal (Vcm-) beaufschlagbar ist, sowie
- einen vierten Varaktor (58), dessen anodischer Anschluss mit dem ersten Tuningsignal (Vcm) und mit dem dritten Tuningsignal (Vcm+) beaufschlagbar ist,
wobei der kathodische Anschluss des dritten Varaktors (56) und der kathodische Anschluss des vierten Varaktors (58) miteinander, mit dem Sourcekontakt oder Emitteranschluss eines dritten Transistors (66) sowie mit dem Drainkontakt oder Kollektoranschluss eines vierten Transistors (68) verbunden sind.

10. Schaltungsanordnung gemäß Anspruch 9, **dadurch gekennzeichnet, dass** der Sourcekontakt oder Emitteranschluss des zweiten Transistors (64) und der Sourcekontakt oder Emitteranschluss des vierten Transistors (68) miteinander sowie mit mindestens einer Stromquelle (60) verbunden sind.

11. Schaltungsanordnung gemäß Anspruch 9 oder 10, **dadurch gekennzeichnet,**
- **dass** der Gatekontakt oder Basisanschluss des ersten Transistors (62) und der Gatekontakt oder Basisanschluss des dritten Transistors (66) miteinander verbunden sowie mit einer Biasspannung oder Vorspannung (Vbias) beaufschlagbar sind und
- **dass** der Drainkontakt oder Kollektoranschluss des ersten Transistors (62) und der Drainkontakt oder Kollektoranschluss des dritten Transistors (66) das Ausgangssignal (Vc) des Kalibrierungsoszillators (50) zur Verfügung stellen.

12. Schaltungsanordnung gemäß mindestens einem der Ansprüche 9 bis 11, **dadurch gekennzeichnet,**
- **dass** ein erstes kalibriertes Ansteuersignal (Vbb) dem ersten Tuningsignal (Vcm) entspricht, insbesondere durch das erste Tuningsignal (Vcm) gegeben ist,
- **dass** ein zweites kalibriertes Ansteuersignal (Vbb) dem zweiten Tuningsignal (Vcm-) entspricht, insbesondere durch das zweite Tuningsignal (Vcm-) gegeben ist, und
- **dass** ein drittes kalibriertes Ansteuersignal (Vbb) dem dritten Tuningsignal (Vcm+) entspricht, insbesondere durch das dritte Tuningsignal (Vcm+) gegeben ist.

13. Verfahren zum Kalibrieren mindestens eines für einen spannungsgesteuerten Oszillator (10) vorgesehenen Ansteuersignals (Vbb),
**dadurch gekennzeichnet**
- **dass** die jeweilige Taktanzahl (N) mindestens eines Kalibrierungsoszillators (50) und mindestens eines dem Kalibrierungsoszillator (50) zugeordneten Referenzoszillators (30) mittels mindestens eines dem Kalibrierungsoszillator (50) und dem Referenzoszillator (30) nachgeschalteten Taktzählers (70) gezählt sowie ein sich aus der Differenz dieser beiden Taktanzahlen (N) ergebender Taktfehler (DE) integriert wird und
- **dass** der Taktfehler (DE) mittels mindestens eines dem Taktzähler (70) nachgeschalteten Digital-Analog-Wandlers (90) in analoge Tuningsignale (Vcm, Vcm-, Vcm+) gewandelt wird, aus denen das kalibrierte Ansteuersignal (Vbb) abgeleitet wird.

14. Verfahren gemäß Anspruch 13, **dadurch gekennzeichnet,**
- **dass** ein erstes kalibriertes Ansteuersignal (Vbb) einem ersten (Vcm) der Tuningsignale (Vcm, Vcm-, Vcm+) entspricht, insbesondere durch ein erstes (Vcm) der Tuningsignale (Vcm, Vcm-, Vcm+) gegeben ist,
- **dass** ein zweites kalibriertes Ansteuersignal (Vbb) einem zweiten (Vcm-) der Tuningsignale (Vcm, Vcm-, Vcm+) entspricht, insbesondere durch ein zweites (Vcm-) der Tuningsignale (Vcm, Vcm-, Vcm+) gegeben ist, und
- **dass** ein drittes kalibriertes Ansteuersignal (Vbb) einem dritten (Vcm+) der Tuningsignale (Vcm, Vcm-, Vcm+) entspricht, insbesondere durch ein drittes (Vcm+) der Tuningsignale (Vcm, Vcm-, Vcm+) gegeben ist.

15. Verwendung mindestens einer Schaltungsanordnung (100) gemäß mindestens einem der Ansprüche 1 bis 12 und/oder eines Verfahrens gemäß Anspruch 13 oder 14 zum Ansteuern mindestens eines spannungsgesteuerten Oszillators (10) für mindestens eine Schaltung zur Takt- und Datenrückgewinnung mit mindestens einem binären Phasendetektor.

## Claims

1. A circuit arrangement (100) for calibrating at least one activation signal (Vbb) provided for a voltage-controlled oscillator (10),
**characterized by**
- at least one calibration oscillator (50),
- at least one reference oscillator (30) associated with the calibration oscillator (50),
- at least one clock counter (70) arranged downstream of the calibration oscillator (50) and the reference oscillator (30) for counting the respective number of clock cycles (N) of the calibration oscillator (50) and the reference oscillator (30) as well as for integrating a clock error (DE) resulting from the difference between these two clock cycles (N), and
- at least one digital/analogue converter (90) arranged downstream of the clock counter (70) for converting the clock error (DE) into analogue tuning signals (Vcm, Vcm-, Vcm+), from which the calibrated activation signal (Vbb) can be derived.

2. The circuit arrangement according to claim 1, **characterized in that** the voltage-controlled oscillator (10) comprises:
- a first varactor (12), the cathodic connection of which is connected with the source contact or emitter connection of a first transistor (22) as well as with the drain contact or collector connection of a second transistor (24), and
- a second varactor (14), the cathode connection of which is connected with the source contact or emitter connection of a third transistor (26) as well as with the drain contact or collector connection of a fourth transistor (28).

3. The circuit arrangement according to claim 2, **characterized in that** the source contact or emitter connection of the second transistor (24) and the source contact or emitter connection of the fourth transistor (28) are connected with each other as well as with at least one current source (20).

4. The circuit arrangement according to claim 2 or 3, **characterized in**
- **that** the gate contact or basis connection of the first transistor (22) and the gate contact or basis connection of the third transistor (26) are connected with each other and that a bias voltage (Vbias) can be applied to them, and
- **that** the drain contact or collector connection of the first transistor (22) and the drain contact or collector connection of the third transistor (26) provide the output signal (Ve) of the voltage-controlled oscillator (10).

5. The circuit arrangement according to at least one of claims 2 to 4, **characterized in that** the calibrated activation signal (Vbb) may be applied to the anodic connection of the first varactor (12) of the voltage-controlled oscillator (10) and to the anodic connection of the second varactor (14) of the voltage-controlled oscillator (10).

6. The circuit arrangement according to at least one of claims 1 to 5 **characterized in that** the reference oscillator (30) comprises:
- a first varactor (32), to the anodic connection of which a reference potential (GND), in particular earth potential or ground potential or zero potential may be applied, as well as
- a second varactor (34), to the anodic connection of which the reference potential (GND) may be applied,
wherein the cathodic connection of the first varactor (32) and the cathodic connection of the second varactor (34) are connected with each other, with the source contact or emitter connection of a first transistor (42) as well as with the drain contact or collector connection of a second transistor (44), and
- a third varactor (36), to the anodic connection of which the reference potential (GND) may be applied, as well as
- a fourth varactor (38), to the anodic connection of which the reference potential (GND) may be applied,
wherein the cathodic connection of the third varactor (36) and the cathodic connection of the fourth varactor (38) are connected with each other, with the source contact or emitter connection of a third transistor (46) as well as with the drain contact or collector connection of a fourth transistor (48).

7. The circuit arrangement according to claim 6, **characterized in that** the source contact or emitter connection of the second transistor (44) and the source contact or emitter connection of the fourth transistor (48) are connected with each other as well as with at least one current source (40).

8. The circuit arrangement according to claim 6 or 7, **characterized in**
- **that** the gate contact or basis connection of the first transistor (42) and the gate contact or basis connection of the third transistor (46) are connected with each other and in that a bias voltage (Vbias) can be applied to them, and
- **that** the drain contact or collector connection of the first transistor (42) and the drain contact or collector connection of the third transistor (46) provide the output signal (Vr) of the reference oscillator (30).

9. The circuit arrangement according to at least one of claims 1 to 8, **characterized in that** the calibration oscillator (50) comprises:
- a first varactor (52), to the anodic connection of which a first (Vcm) of the tuning signals (Vcm, Vcm-, Vcm+) and a second (Vcm-) of the tuning signals (Vcm, Vcm-, Vcm+) can be applied, as well as
- a second varactor (54), to the anodic connection of which the first tuning signal (Vcm) and a third (Vcm+) of the tuning signals (Vcm, Vcm-, Vcm+) can be applied,
wherein the cathodic connection of the first varactor (52) and the cathodic connection of the second varactor (54) are connected with each other, with the source contact or emitter connection of a first transistor (62) as well as with the drain contact or collector connection of the second transistor (64), and
- a third varactor (56), to the anodic connection of which the first tuning signal (Vcm) and the second tuning signal (Vcm-) can be applied, as well as
- a fourth varactor (58), to the anodic connection of which the first tuning signal (Vcm) and the third tuning signal (Vcm+) can be applied,
wherein the cathodic connection of the third varactor (56) and the cathodic connection of the fourth varactor (58) are connected with each other, with the source contact or emitter connection of a third transistor (66) as well as with the drain contact or collector connection of a fourth transistor (68).

10. The circuit arrangement according to claim 9, **characterized in that** the source contact or emitter connection of the second transistor (64) and the source contact or emitter connection of the fourth transistor (68) are connected with each other and with at least one current source (60).

11. The circuit arrangement according to claim 9 or 10, **characterized in**
- **that** the gate contact or basis connection of the first transistor (62) and the gate contact or basis connection of the third transistor (66) are connected with each other and to which a bias voltage (Vbias) can be applied, and
- **that** the drain contact or collector connection of the first transistor (62) and the drain contact or collector connection of the third transistor (66) provide the output signal (Vc) of the calibration oscillator (50).

12. The circuit arrangement according to at least one of claims 9 to 11, **characterized in**
- **that** a first calibrated activation signal (Vbb) corresponds to the first tuning signal (Vcm), in particular constitutes the first tuning signal (Vcm),
- **that** in second calibrated activation signal (Vbb) corresponds to the second tuning signal (Vcm-), in particular constitutes the second tuning signal (Vcm-), and
- **that** a third calibrated activation signal (Vbb) corresponds to the third tuning signal (Vcm+), in particular constitutes the third tuning signal (Vcm+).

13. A method for calibrating at least one activation signal (Vbb) provided for a voltage-controlled oscillator (10),
**characterized in**
- **that** the respective number of clock cycles (N) of at least one calibration oscillator (50) and of at least one reference oscillator (30) associated with the calibration oscillator (50) is counted by means of at least one clock counter (70) arranged downstream of the calibration oscillator (50) and the reference oscillator (30), and a clock error (DE) resulting from the difference between these two numbers of clock cycles (N) is integrated, and
- **that** the clock error (DE) is converted by means of at least one digital/analogue converter (90) arranged downstream of the clock counter (70) into analogue tuning signals (Vcm, Vcm-, Vcm+), from which the calibrated activation signal (Vbb) is derived.

14. The method according to claim 13, **characterized in**
- **that** a first calibrated activation signal (Vbb) corresponds to a first (Vcm) of the tuning signals (Vcm, Vcm-, Vcm+), in particular constitutes a first (Vcm) of the tuning signals (Vcm, Vcm-, Vcm+),
- **that** a second calibrated activation signal (Vbb) corresponds to a second (Vcm-) of the tuning signals (Vcm, Vcm-, Vcm+), in particular constitutes a second (Vcm-) of the tuning signals (Vcm, Vcm-, Vcm+) gegeben ist, and
- **that** a third calibrated activation signal (Vbb) corresponds to a third (Vcm+) of the tuning signals (Vcm, Vcm-, Vcm+), in particular constitutes a third (Vcm+) of the tuning signals (Vcm, Vcm-, Vcm+).

15. Use of at least one circuit arrangement (100) according to at least one of claims 1 to 12 and/or a method according to claim 13 or 14 for activating at least one voltage-controlled oscillator (10) for at least one circuit for clock and data recovery with at least one binary phase detector.

## Revendications

1. Circuit (100) pour l'étalonnage d'au moins un signal de commande (Vbb) prévu pour un oscillateur commandé en tension (10),
**caractérisé par**
- au moins un oscillateur d'étalonnage (50),
- au moins un oscillateur de référence (30) associé à l'oscillateur d'étalonnage (50),
- au moins un compteur de cycles (70) monté en aval de l'oscillateur d'étalonnage (50) et de l'oscillateur de référence (30) pour le comptage du nombre respectif de cycles (N) de l'oscillateur d'étalonnage (50) et de l'oscillateur de référence (30) ainsi que pour l'intégration d'une erreur de cycle (DE) résultant de la différence entre ces deux nombres de cycles (N), et
- au moins un convertisseur numérique/analogique (90) monté en aval du compteur de cycles (70) pour convertir l'erreur de cycle (DE) en signaux de syntonisation analogiques (Vcm, Vcm-, Vcm+) dont il est possible de déduire le signal de commande étalonné (Vbb).

2. Circuit selon la revendication 1, **caractérisé en ce que** l'oscillateur commandé en tension (10) présente:
- un premier varactor (12) dont la borne cathodique est reliée au contact de source ou à la borne d'émetteur d'un premier transistor (22) ainsi qu'à un contact de drain ou une borne de collecteur d'un deuxième transistor (24), et
- un deuxième varactor (14) dont la borne cathodique est reliée au contact de source ou à la borne d'émetteur d'un troisième transistor (26) ainsi qu'au contact de drain ou à la borne de collecteur d'un quatrième transistor (28).

3. Circuit selon la revendication 2, **caractérisé en ce que** le contact de source ou la borne d'émetteur du deuxième transistor (24) et le contact de source ou la borne d'émetteur du quatrième transistor (28) sont reliés ensemble ainsi qu'à au moins une source de courant (20).

4. Circuit selon la revendication 2 ou 3, **caractérisé en ce**
- **que** le contact de grille ou la borne de base du premier transistor (22) et le contact de grille ou la borne de base du troisième transistor (26) sont reliés ensemble et peuvent être alimentés par une tension de polarisation ou une polarisation (Vbias) et
- **que** le contact de drain ou la borne de collecteur du premier transistor (22) et le contact de drain ou la borne de collecteur du troisième transistor (26) mettent à disposition le signal de sortie (Ve) de l'oscillateur commandé en tension (10).

5. Circuit selon au moins l'une des revendications 2 à 4, **caractérisé en ce que** la borne anodique du premier varactor (12) de l'oscillateur commandé en tension (10) et la borne anodique du deuxième varactor (14) de l'oscillateur commandé en tension (10) peuvent être alimentées par le signal de commande étalonné (Vbb).

6. Circuit selon au moins l'une des revendications 1 à 5, **caractérisé en ce que** l'oscillateur de référence (30) présente:
- un premier varactor (32) dont la borne anodique peut être alimentée par un potentiel équivalent ou potentiel de référence (GND), en particulier un potentiel de terre ou un potentiel de masse ou un potentiel nul, et
- un deuxième varactor (34) dont la borne anodique peut être alimentée avec le potentiel équivalent ou potentiel de référence (GND),
dans lequel la borne cathodique du premier varactor (32) et la borne cathodique du deuxième varactor (34) sont reliées ensemble, au contact de source ou à la borne d'émetteur d'un premier transistor (42) ainsi qu'au contact de drain ou à la borne de collecteur d'un deuxième transistor (44), et
- un troisième varactor (36) dont la borne anodique peut être alimentée avec le potentiel équivalent ou potentiel de référence (GND), et
- un quatrième varactor (38), dont la borne anodique peut être alimentée avec le potentiel équivalent ou potentiel de référence (GND),
dans lequel la borne cathodique du troisième varactor (36) et la borne cathodique du quatrième varactor (38) sont reliées ensemble, au contact de source ou à la borne d'émetteur d'un troisième transistor (46), ainsi qu'au contact de drain ou à la borne de collecteur d'un quatrième transistor (48).

7. Circuit selon la revendication 6, **caractérisé en ce que** le contact de source ou la borne d'émetteur du deuxième transistor (44) et le contact de source ou la borne d'émetteur du quatrième transistor (48) sont reliés ensemble ainsi qu'à au moins une source de courant (40).

8. Circuit selon la revendication 6 ou 7, **caractérisé en ce**
- **que** le contact de grille ou la borne de base du premier transistor (42) et le contact de grille ou la borne de base du troisième transistor (46) sont reliés ensemble et peuvent être alimentés par une tension de polarisation ou polarisation (Vbias), et
- **que** le contact de drain ou la borne de collecteur du premier transistor (42) et le contact de drain ou la borne de collecteur du troisième transistor (46) mettent à disposition le signal de sortie (Vr) de l'oscillateur de référence (30).

9. Circuit selon au moins l'une des revendications 1 à 8, **caractérisé en ce que** l'oscillateur d'étalonnage (50) présente:
- un premier varactor (52) dont la borne anodique peut être alimentée par un premier (Vcm) des signaux de syntonisation (Vcm, Vcm-, Vcm+) et par un deuxième (Vcm-) des signaux de syntonisation (Vcm, Vcm-, Vcm+), et
- un deuxième varactor (54), dont la borne anodique peut être alimentée par le premier signal de syntonisation (Vcm) et par un troisième (Vcm+) des signaux de syntonisation (Vcm, Vcm-, Vcm+),
dans lequel la borne cathodique du premier varactor (52) et la borne cathodique du deuxième varactor (54) sont reliées ensemble, au contact de source ou à la borne d'émetteur d'un premier transistor (62), ainsi qu'au contact de drain ou à la borne de collecteur d'un deuxième transistor (64), et
- un troisième varactor (56) dont la borne anodique peut être alimentée par le premier signal de syntonisation (Vcm) et par le deuxième signal de syntonisation (Vcm-), et
- un quatrième varactor (58), dont la borne anodique peut être alimentée par le premier signal de syntonisation (Vcm) et par le troisième signal de syntonisation (Vcm+),
dans lequel la borne cathodique du troisième varactor (56) et la borne cathodique du quatrième varactor (58) sont reliées ensemble, au contact de source ou à la borne d'émetteur d'un troisième transistor (66), ainsi qu'au contact de drain ou à la borne de collecteur d'un quatrième transistor (68).

10. Circuit selon la revendication 9, **caractérisé en ce que** le contact de source ou la borne d'émetteur du deuxième transistor (64) et le contact de source ou la borne d'émetteur du quatrième transistor (68) sont reliés ensemble ainsi qu'à au moins une source de courant (60).

11. Circuit selon la revendication 9 ou 10, **caractérisé en ce**
- **que** le contact de grille ou la borne de base du premier transistor (62) et le contact de grille ou la borne de base du troisième transistor (66) sont reliés ensemble et peuvent être alimentés par une tension de polarisation ou polarisation (Vbias), et
- **que** le contact de drain ou la borne de collecteur du premier transistor (62) et le contact de drain ou la borne de collecteur du troisième transistor (66) mettent à disposition le signal de sortie (Vc) de l'oscillateur d'étalonnage (50).

12. Circuit selon au moins l'une des revendications 9 à 11, **caractérisé en ce**
- **qu'**un premier signal de commande étalonné (Vbb) correspond au premier signal de syntonisation (Vcm), en étant en particulier donné par le premier signal de syntonisation (Vcm),
- **qu'**un deuxième signal de commande étalonné (Vbb) correspond au deuxième signal de syntonisation (Vcm-), en étant en particulier donné par le deuxième signal de syntonisation (Vcm-), et
- **qu'**un troisième signal de commande étalonné (Vbb) correspond au troisième signal de syntonisation (Vcm+), en étant en particulier donné par le troisième signal de syntonisation (Vcm+).

13. Procédé pour l'étalonnage d'au moins un signal de commande (Vbb) prévu pour un oscillateur commandé en tension (10),
**caractérisé en ce**
- **que** le nombre respectif de cycles (N) d'au moins un oscillateur d'étalonnage (50) et d'au moins un oscillateur de référence (30) associé à l'oscillateur d'étalonnage (50) est compté au moyen d'au moins un compteur de cycles (70) monté en aval de l'oscillateur d'étalonnage (50) et de l'oscillateur de référence (30) et une erreur de cycle (DE) résultant de la différence entre ces deux nombres de cycles (N) étant intégrée, et
- **que** l'erreur de cycle (DE) est convertie au moyen d'au moins un convertisseur analogique/numérique (90) monté en aval du compteur de cycles (70) en signaux de syntonisation analogiques (Vcm, Vcm-, Vcm+) dont le signal de commande étalonné (Vbb) est déduit.

14. Procédé selon la revendication 13, **caractérisé en ce**
- **qu'**un premier signal de commande étalonné (Vbb) correspond à un premier (Vcm) des signaux de syntonisation (Vcm, Vcm-, Vcm+), en étant en particulier donné par un premier (Vcm) des signaux de syntonisation (Vcm, Vcm-, Vcm+),
- **qu'**un deuxième signal de commande étalonné (Vbb) correspond à un deuxième (Vcm-) des signaux de syntonisation (Vcm, Vcm-, Vcm+), en étant en particulier donné par un deuxième (Vcm-) des signaux de syntonisation (Vcm, Vcm-, Vcm+), et
- **qu'**un troisième signal de commande étalonné (Vbb) correspond à un troisième (Vcm+) des signaux de syntonisation (Vcm, Vcm-, Vcm+), en étant en particulier donné par un troisième (Vcm+) des signaux de syntonisation (Vcm, Vcm-, Vcm+).

15. Utilisation d'au moins un circuit (100) selon au moins l'une des revendications 1 à 12 et/ou d'un procédé selon la revendication 13 ou 14 pour la commande d'au moins un oscillateur commandé en tension (10) pour au moins un circuit pour la récupération de cycles et de données avec au moins un détecteur de phase binaire.
